# EUROPÄISCHE PATENTSCHRIFT

(11) **EP 1 510 592 B1**
(45) Veröffentlichungstag und Bekanntmachung des Hinweises auf die Patenterteilung: **26.12.2012**
(21) Anmeldenummer: 03024366.1
(22) Anmeldetag: 24.10.2003
(51) Int. Cl.: C23C 4/00, C23C 8/04, C23C 10/04, C23C 14/04, C23C 16/04, B05B 15/04

(54) **Verfahren zur Beschichtung eines Bauteils und Bauteil**
Method for coating an object and object
Procédé pour revêtir un objet et objet

(30) Priorität: 28.08.2003 EP 03019470
(43) Veröffentlichungstag der Anmeldung: 02.03.2005
(73) Patentinhaber: SIEMENS AKTIENGESELLSCHAFT, 80333 München (DE)
(72) Erfinder: Berndt, Thomas, 12524 Berlin (DE); Cox, Nigel-Philip, 10119 Berlin (DE); Griep, Andreas, 16356 Ahrensfelde (DE); Kern, Guido, 13158 Berlin (DE); Reich, Gerhard, 10717 Berlin (DE); Sindlhauser, Peter, 87463 Dietmannsried (DE)
(74) Vertreter: Maier, Daniel Oliver

(56) Entgegenhaltungen:
- EP-A- 1 076 107
- EP-A- 1 076 109
- EP-A- 1 076 111
- EP-A- 1 352 988
- EP-A- 1 352 989
- US-A- 5 725 905
- US-A- 6 107 598
- US-B1- 6 253 441
- "Selective masking of workpiece prior to carburising, nitriding etc. - is carried out using porous inorganic layer followed by high m.pt. metal" DERWENT, XP002230816

## Beschreibung

Die Erfindung betrifft ein Verfahren zur Beschichtung eines Bauteils gemäß dem Gattungsbegriff des Anspruchs 1 und ein Bauteil gemäß dem Gattungsbegriff des Anspruchs 23.

Bei der Beschichtung von Bauteilen soll nicht immer die gesamte äußere oder innere Oberfläche eines Bauteils beschichtet werden. Dies gilt für sämtliche Beschichtungsverfahren, wie z.B. Plasmaspritzen, PVD-(physical vapour deposition) oder CVD- (chemical vapour deposition) Prozesse.

Teile der Beschichtung müssen dort entfernt werden, in denen keine Beschichtung erwünscht war. Dies geschieht oft durch eine abrasive Abtragung der Beschichtung in diesen Bereichen, da das Material der Beschichtung sehr gut auf dem Bauteil haftet oder sogar mit diesem reagiert, wenn z.B. das Bauteil mit Aluminium beschichtet wurde, um eine Alitierung durchzuführen.
Die abrasive Abtragung führt jedoch zu einer Schädigung oder Geometrieveränderung des Bauteils. Dies ist z.B. beim Sandstrahlen der Fall, bei dem die Sandpartikel beispielsweise das Aluminium von dem Bauteil wieder entfernen.

Die EP 1 076 111 A2 offenbart ein Innenalitierungsverfahren, bei dem äußere Flächen durch ein massives Material geschützt werden, wobei dies eine Metall oder Graphitfolie sein kann.

Die US 6,107,598 offenbart eine Pulvermischung zum Schutz beim Laserschweißen oder Laserbohren, die eine Mischung aus einem Metall und einem kolloidialen Siliziumoxid aufweist.

Die US-PS 6,036,995 zeigt die Notwendigkeit von Maskierungen durch Klebebänder, Metallfolien. Die Beschichtung erfolgt durch Auftrag von Schlicker. Metallfolien haften nicht gut auf einer Unterlagen und bieten daher unzureichenden Schutz in einer Bedampfungsanlage, in der die aufzutragenden Teilchen sich in allen Richtungen bewegen.
Klebebänder halten keine hohen Temperaturen aus.

Bei der US-PS 5,985,368 erfolgt eine Beschichtung durch einen Schlicker aus Keramik. Es findet keine Maskierung statt.

Die US-PS 6,283,714 zeigt die Notwendigkeit von Maskierungen bei Beschichtungen mit Aluminium. Durch eine bestimmte Anordnung innerhalb der Beschichtungsanlage wird aber vermieden, dass sich Aluminium auf den ungewünschten Stellen abscheidet.

Die GB 2 210 387 A beschreibt, dass eine Maskierung durch einen Schlicker oder Paste aufgetragen wird, wobei ein Binder enthalten ist.

Die JP 11 181 561 offenbart eine Maskierung, wobei die Maskierung aus einen organischem Lösungsmittel, einem organischen Binder und einem Pulver besteht.
Dies ist eine allgemeine Vorgehensweise. Pulver mit Binder in einem Trägermittel wird auf ein Bauteil aufgebracht.
Der Binder hält das Pulver zusammen, wird nach dem Auftragen und Verdampfen des Trägermittels ausgebrannt und das Pulver wird versintert, damit es stabil bleibt

Es ist daher Aufgabe der Erfindung ein Verfahren zur Beschichtung eines Bauteils aufzuzeigen, bei dem durch eine Maskierung eine Beschichtung des Bauteils in den unerwünschten Bereichen unterbleibt, wobei die Maskierung auf einfache Art und Weise nach Durchführung der Beschichtung wieder entfernt werden kann.

Die Aufgabe wird durch ein Verfahren gemäß Anspruch 1 gelöst. Dabei wird die Oberfläche in den Bereichen des Bauteils, in denen keine Beschichtung erwünscht ist, nur durch Pulver bzw. eine Pulverschicht geschützt.
Bei der Aufbringung der Maskierungsschicht auf das Bauteil, die nur aus Pulver besteht, wird kein Binder verwendet.

In den Unteransprüchen sind weitere vorteilhafte Verbesserungen des Verfahrens gemäß Anspruch 1 aufgelistet.
Die in den Unteransprüchen aufgelisteten Maßnahmen können in vorteilhafter Art und Weise miteinander kombiniert werden.

Das Pulver muss, um eine Maskierungsschicht zu bilden, in einem ersten Verfahrensschritt auf das Bauteil aufgebracht werden.
Die Maskierungsschicht aus Pulver kann in vorteilhafter Art und Weise mittels einer Suspension auf das Bauteil aufgetragen werden, wobei auch die Suspension keinen Binder enthält, sonder nur aus dem Pulver und einem Trägermittel besteht, das leicht verdampfen kann, aber nicht wie ein Binder zu einer verbesserten Haftung der Körner des Pulvers untereinander führt.

Besonders vorteilhaft ist es, wenn die Suspension aus Wasser und einem Keramikpulver besteht, da Wasser ein optimales Trägermittel ist und nicht gesundheitsgefährdend ist.

Besonders vorteilhaft ist dabei auch die Verwendung von Oxidkeramiken, die im Wasser nicht oxidieren. Dabei wird insbesondere Zirkonoxid verwendet.

Zirkonoxid ist für Maskierungen auf metallischen Substraten vielfach auch deshalb von Vorteil, da auch eventuelle Verunreinigungen durch Eindiffundieren von Zirkon in das Substrat dessen mechanische Eigenschaften nicht verschlechtert. Im Gegenteil wird Zirkonoxid oft als erwünschte Beigabe einer Legierung hinzugefügt.

Eine gute Maskierung wird durch die Verwendung von zwei Pulvern erreicht, die verschiedene Korngrößenverteilungen (grob/fein) aufweisen.

Es ist außerdem Aufgabe der Erfindung ein Bauteil aufzuzeigen, bei dem durch eine Maskierung eine Beschichtung in den unerwünschten Bereichen unterbleibt, wobei die Maskierung später von dem beschichteten Bauteil auf einfache Art und Weise wieder entfernt werden kann.

Die Aufgabe wird durch ein Bauteil gemäß Anspruch 23 gelöst. Dabei weist das Bauteil eine Maskierungsschicht auf, die nur aus Pulver besteht.

Die Maskierungsschicht weist vorteilhafterweise keinen Binder auf.
Ebenfalls wird auf die Verwendung eines Binders beim Auftragen der Maskierungsschicht verzichtet.

In den Unteransprüchen sind weitere vorteilhafte Verbesserungen des Bauteils gemäß Anspruch 23 aufgelistet.
Die in den Unteransprüchen aufgelisteten Maßnahmen können in vorteilhafter Art und Weise miteinander kombiniert werden.

Weiterhin ist es Aufgabe der Erfindung ein Pulver aufzuzeigen, das für eine Maskierung verwendet werden kann, die eine Beschichtung in den unerwünschten Bereichen des Bauteils verhindert.

Dabei weist das Pulver einen Grob- und einen Feinanteil auf.

Ausführungsbeispiele sind in den nachfolgenden Figuren erläutert.

Es zeigen
- Figur 1, 2, 3, 6: die Verfahrensschritte des erfindungsgemäßen Verfahrens,
- Figur 4, 5: weitere Ausführungsbeispiele für die Anwendung des erfindungsgemäßen Verfahrens,
- Figur 7: Eigenschaften des verwendeten Pulvers,
- Figur 8: Korngrößenverteilungskurven eines Pulvergemischs und der Ausgangspulver,
- Figur 10, 11, 12: erfindungsgemäße Bauteile,

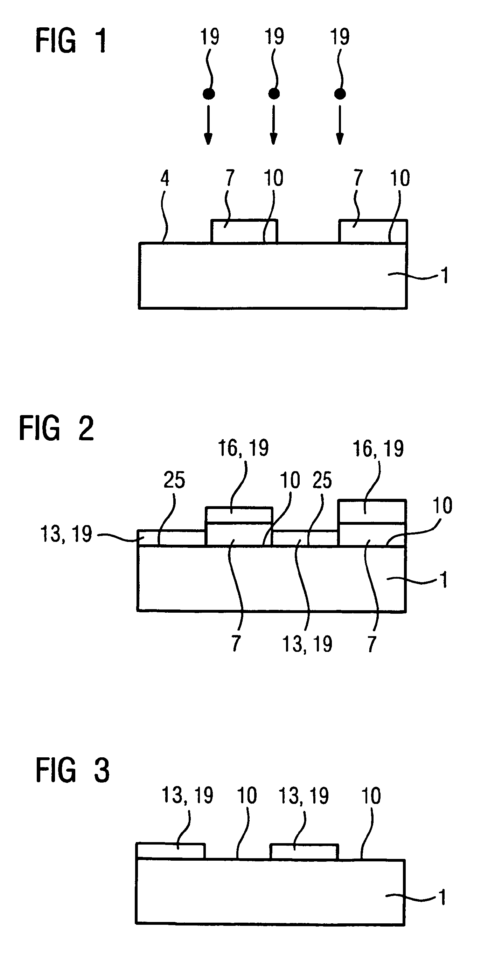

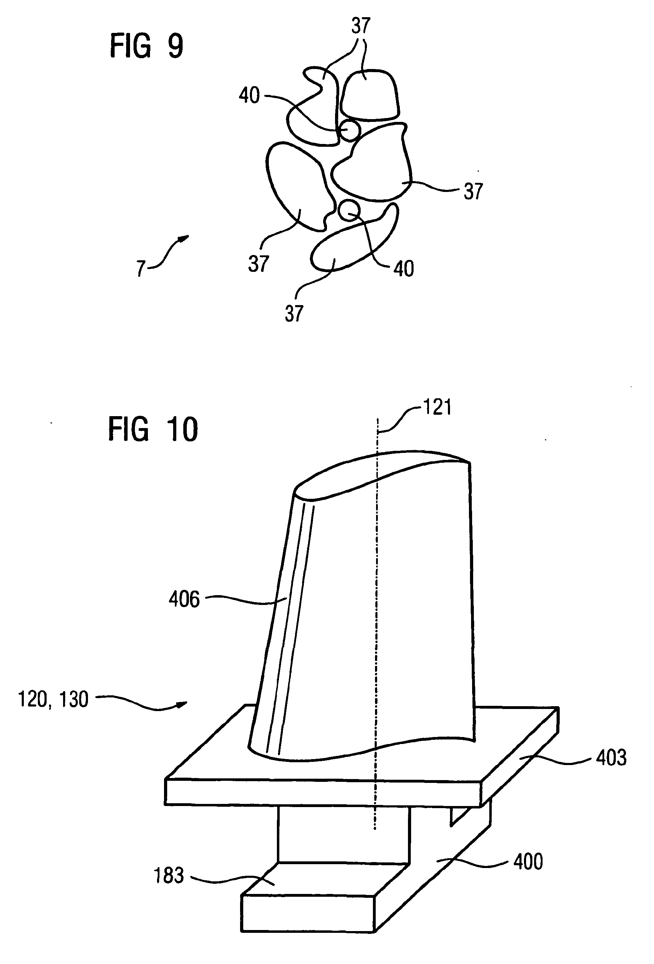

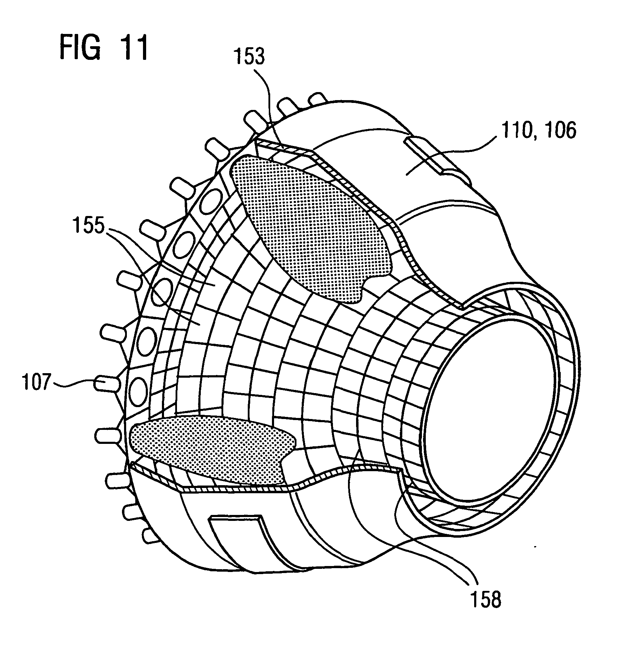

Figur 1 zeigt ein Bauteil 1, insbesondere eine Turbinenschaufel 120, 130 (Fig. 11), Brennkammerteil 153, 155 (Fig. 10) oder ein Gehäuseteil einer Gas- 100 oder Dampfturbine, beispielsweise bestehend aus einer eisen-, nickel- oder kobalt-basierten Superlegierung, das eine Oberfläche 4 aufweist.
Die nickel- oder kobalt-basierte Superlegierung kann auch Zirkon zu geringen Mengen als Legierungsbestandteil aufweisen.

Die Oberfläche 4 des Bauteils 1 soll mit einem keramischen oder metallischen Beschichtungsmaterial 19, wie z.B. Aluminium, beschichtet werden, wobei die Beschichtung insbesondere aus einer Dampfphase aufgebracht wird.
Dabei gibt es Bereiche 10, in denen eine Beschichtung 13 mit dem Beschichtungsmaterial 19 nicht erwünscht ist, wie z.B. ein Schaufelfuß 183 (Fig. 9) einer Turbinenschaufel 120, 130.

Diese Bereiche 10 werden durch eine Maskierung 7 geschützt, die als Pulverschicht 7 auf dem Bauteil 1, 120, 130, 153, 155 ausgebildet ist.
Dabei muss das Pulver auf das Bauteil 1 aufgebracht werden. Die Maskierung 7 wird beispielsweise in Form einer Suspension (im folgenden beispielhaft erläutert), einem Schlicker oder einer Paste eines Pulvers ohne Binder auf die Bereiche 10 aufgebracht, der nach dem Stand der Technik verwendet wird, um eine Pulverschicht (Grünschicht) zusammenzuhalten.
Die Maskierung 7 bleibt während der Beschichtung des Bauteils 1, 120, 130, 153, 155 auf dem Bauteil 1, 120, 130, 153, 155 haften.

Die Suspension besteht nur aus einem flüssigen Trägermittel und dem Pulver.
Als Trägermittel eignen sich beispielsweise Alkohole und insbesondere Wasser. Wasser verflüchtigt sich nicht so schnell beim Auftragen der Suspension, so dass das Trocknungsverhalten eingestellt und kontrolliert werden kann und stellt außerdem kein gefährliches Arbeitsmittel dar.
Dabei wird vorteilhaft 30wt% bis 50wt%, insbesondere 40wt% Wasser und 50wt% bis 70wt%, insbesondere 60wt% Pulver verwendet.
Die Suspension wird durch Rühren oder sonstige Anregung während des Auftragungsprozesses der Maskierung 7 ständig durch sehr hohen kinetischen Eintrag, insbesondere durch einen Dissolver, durchmischt, so dass sich das Pulver in der Suspension nicht absetzt und/oder Agglomerate von Pulverkörnern aufgebrochen werden und sich keine neuen Agglomerate bilden. Für das Auftragen wird ein entsprechender Strahlmischkopf verwendet, der eine Vertikalströmung und hohe Drehzahlen von bis zu 10000/min aufweist.

Gegebenenfalls können Stabilisatoren in dem Trägermittel enthalten sein, die aber mit dem Trägermittel nach dem Auftrag der Suspension sich verflüchtigen oder verdampfen.

Die Maskierung 7 kann auch durch Eintauchen des Bauteils 1, 120, 130, 153, 155 in die Suspension, Bepinseln, Aufsprühen oder sonstige Auftragungsarten auf das Bauteil 1, 120, 130, 153, 155 in den Bereichen 10 aufgebracht werden.
Insbesondere eignet sich das Aufsprühen der Suspension.

Dabei wird vorzugsweise eine Dicke von 100 bis 400 Mikrometer (µm), insbesondere 180 bis 200 Mikrometern für die Maskierung 7 erreicht.

Die Auftragung kann lokal oder auch großflächig erfolgen.
Da dieses Aufsprühen bei Raumtemperatur erfolgt, können die anderen Bereiche 25, also die, bei denen später eine Beschichtung 13 erfolgen soll, beispielsweise durch Klebeband abgedeckt werden, welches sich einfach und ohne Rückstände entfernen lässt.

Das Trägermittel verflüchtigt sich oder verdampft. Dazu kann die Maskierung 7 leicht erwärmt werden.

Die Pulverschicht (Maskierung 7) sollte eine derart geschlossene Oberfläche bilden, dass kein Material 19, insbesondere Metall- oder Keramikdampf bei einer folgenden Beschichtung durch die Maskierung 7 bis zu der Oberfläche 4 in den Bereichen 10 hindurchdringen kann.

Das Pulver der Maskierung 7 kann so ausgewählt werden, dass das Material 19 der folgenden Beschichtung 13 an dem Pulver aufgrund dessen Oberflächeneigenschaften (Rauhigkeit, ..) abperlt, so dass kein Material 19 der folgenden Beschichtung 13 durch die Maskierung 7 hindurchdringen kann.
Ebenso kann das Pulver der Maskierung 7 so ausgewählt werden, dass das Material 19 der folgenden Beschichtung an dem Pulver besonders gut haftet, so dass ggf. vorhandene kleine Poren oder Risse der Maskierung 7 verschlossen werden und eine Durchdringung der Maskierung 7 mit dem Material 19 der folgenden Beschichtung 13 verhindert wird.

Durch geeignete Wahl einer Korngrößenverteilung des Pulvers werden die gewünschten Eigenschaften einer hinreichend großen Haftung der Pulverschicht auf dem Substrat und die Bildung einer ausreichend geschlossenen Oberfläche erreicht.

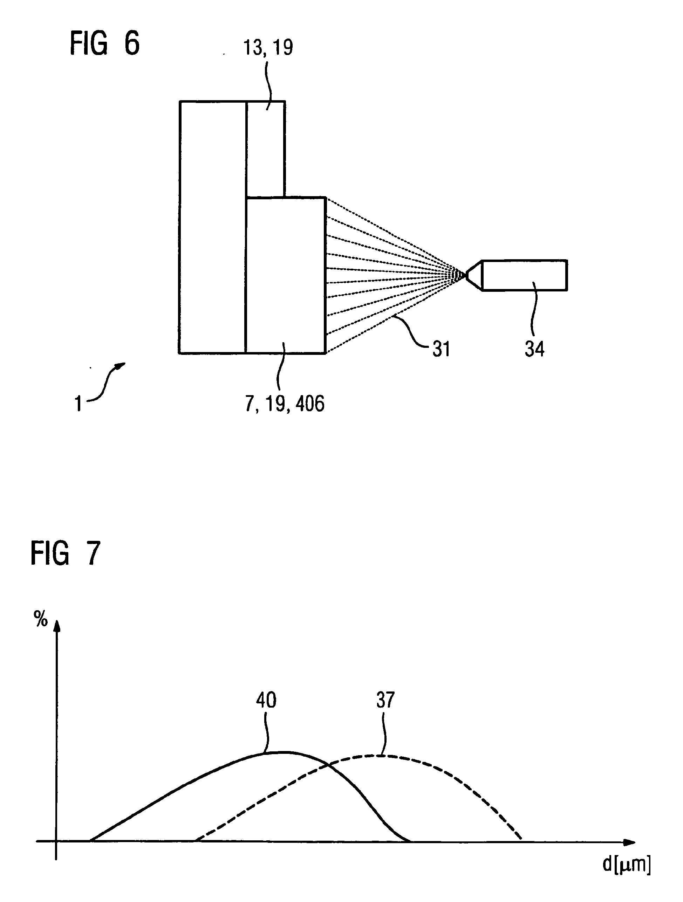

Bei der Herstellung eines Pulvers ergibt sich für das Material des Pulvers und die Herstellungsart eine spezifische Korngrößenverteilung. Eine solche Korngrößenverteilung eines Pulvers (37, 40) zeigt die Figur 7, in der die Häufigkeit der Korngröße d(µm) aufgetragen ist.

Zweckmäßige mittlere Kornverteilungen liegen in folgenden Bereichen:
d₁₀ = 0.1µm bis 6µm, insbesondere 0.2µm bis 1µm,
d₅₀ = 1µm bis 15µm, insbesondere 3µm bis 6µm,
d₉₀ = 6µm bis 40µm, insbesondere 15µm bis 25µm.

Durch Sieben kann der Anfangsbereich und/oder der Endbereich der Korngrößenverteilung ausgesiebt werden.

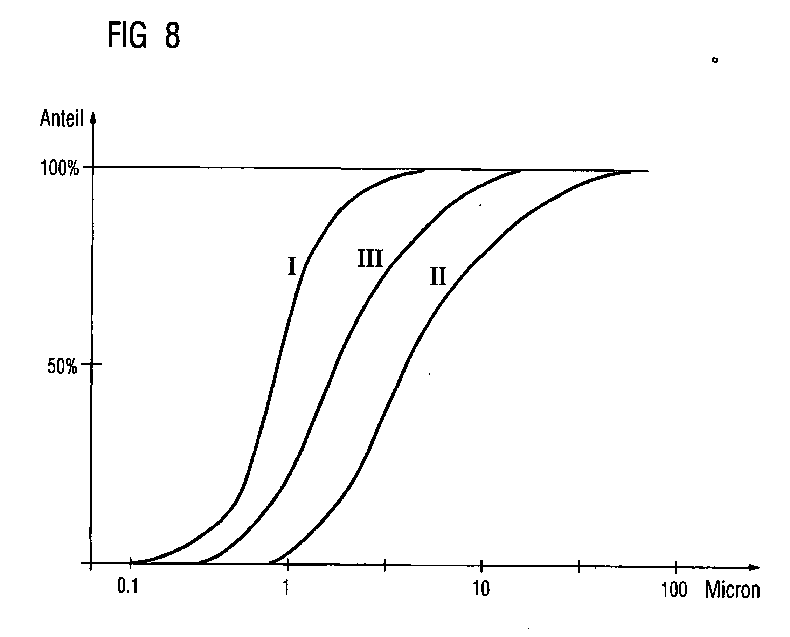

Für die Maskierung 7 kann ein Pulver verwendet werden, das von vornherein bereits die notwendigen Korngrößen-Eigenschaften mit den d₁₀ , d₅₀ oder d₉₀ Werten aufweist.
Es kann aber auch eine Pulvermischung verwendet werden, d.h. für die Maskierung 7 werden verschiedene Pulver 37, 40, d.h. verschiedene Korngrößenverteilungen gemäß Figur 7 oder 8 verwendet.
Hier wird beispielsweise ein grobes 37 und ein feines Pulver 40 vermischt und für die Maskierung verwendet.
Es können aber auch drei, vier oder mehr Pulver vermischt werden.

Die Lage der Korngrößenverteilungen der Pulver 37, 40 in Figur 7 ist nur schematisch dargestellt. Insbesondere die Lage der Überlappung der Kurven 37, 40 kann variiert werden. Insbesondere sind beispielsweise zwei Maxima in der Häufigkeit der Korngrößenverteilung des Pulvers oder der Pulvermischung erkennbar, die den Grobanteil 37 und den Feinanteil 40 darstellen.
Die Morphologie der Körner des feinen Pulvers 40 und des groben Pulvers 37 kann unterschiedlich sein.

Figur 8 zeigt eine beispielhafte Korngrößenverteilung (Mikron = Mikrometer) eines verwendeten Pulvergemischs III und seiner Ausgangspulver I, II.
Das Pulvergemisch III ist gebildet aus einer Pulvermischung I (= 40) und II (= 37) und weist Korngrößen von größer 0.2µm bis etwas kleiner 20µm auf (Faktor 100 zwischen kleinster und größter Korngröße).
Ein bestimmtes Anteilsverhältnis der Pulver I und II wird eingestellt, um diese Korngrößenverteilung zu erreichen.
Das Pulver I weist Korngrößen von etwa 0.1µm bis etwa 5µm auf (Faktor 50 zwischen kleinster und größter Korngröße).
Das Pulver II weist Korngrößen von etwa 0.8µm bis etwa 60µm auf (Faktor 75 zwischen kleinster und größter Korngröße)
und zeigt daher einen flacheren Verlauf als die Korngrößenverteilung des feineren Pulvers I.
Prinzipiell liegt natürlich die Pulvermischung III mit ihren Korngrößen zwischen der kleinsten Korngröße und der größten Korngröße der Pulver I und II. Durch die Mischung und aufgrund der Meßgenauigkeit zur Bestimmung der Korngrößen, fallen die unteren und oberen Bereiche der Kurve III sehr gering aus.

Figur 9 zeigt ein Ausschnitt aus einer Maskierung 7, die aus zwei Pulvern 37, 40 besteht, die verschiedene Korngrößenverteilungen (feines Pulver 40, grobes Pulver 37) gemäß Figur 7 aufweisen.

Die Maskierung 7 aus einer solchen Pulvermischung weist daher grobe Pulverkörner 37 sowie kleinere oder feine Pulverkörner 40 auf.

Insbesondere wird das feine Pulver 40 so gewählt, dass sich die kleineren oder feineren Körner des feinen Pulvers 40 in den Zwischenräumen zwischen den groben Teilchen 37 befinden. Dadurch wird eine dichte, also ausreichend geschlossene Oberfläche in der Maskierung 7 und/oder eine gute Festigkeit der Maskierung 7 erreicht.

Dabei wird 10wt% bis 30wt%, insbesondere 15wt% bis 20wt% feines Pulver 40 und 70wt& bis 90 wt%, insbesondere 80wt% bis 85wt% grobes Pulver 37 verwendet.
Das feine Pulver 40 führt zu einer guten Haftung der Maskierung 7 auf dem Bauteil 1, da es durch Verklammerung die gröberen Pulverteilchen besser miteinander verkoppelt. Das feine Pulver wirkt als eine Art Schmiermittel, das den Binder ersetzt.

Jedes Pulver weist aufgrund seiner Korngröße (Korngrößenverteilung) eine Sintertemperatur auf, bei der eine deutliche Verdichtung und Verbindung der Körner untereinander stattfindet.
Die Korngröße des groben Pulvers 37 kann so gewählt werden, dass die Sintertemperatur des groben Pulvers 37 oberhalb der Beschichtungstemperatur für die Beschichtung 13 liegt.
Da sich das feine Pulver 40 der Maskierung 7 eher in den Zwischenräumen des groben Pulvers 37 befindet und/oder sich nicht so sehr untereinander berührt, findet bei dem feinen Pulver 40 keine oder kaum eine Versinterung des feinen Pulvers statt. Die Auswahl der Korngröße eines Pulvers bei vorgegebener Beschichtungstemperatur kann also hauptsächlich nach dem groben Pulver 37 getroffen werden.
Die Beschichtungstemperatur für die Beschichtung 13 kann natürlich höher als die Sintertemperatur des feinen Pulvers 40 sein und damit zwischen den Sintertemperaturen des groben Pulvers 37 und des feinen Pulvers 40 liegen.
Die Beschichtungstemperatur für die Beschichtung 13 kann natürlich auch niedriger als die Sintertemperatur des feinen Pulvers 40 sein.

Eine Versinterung des Pulvers ist vor (also nach dem Auftrag der Maskierungsschicht 7 und Verdampfen des Trägermittels) und während der Beschichtung nicht notwendig.
Während der Beschichtung kann aber eine Versinterung zugelassen werden.

Bei besonders großen Flächen der Maskierungsschicht 7 ist kann eine zumindest teilweise Versinterung sinnvoll sein, um die mechanische Stabilität der Maskierungsschicht 7 zu verbessern.

Das Pulver für die Maskierung 7 wird so ausgewählt, dass es nicht mit dem Bauteil 1 reagiert.
Dies ist bei der Verwendung von Zirkonoxid als Pulver und insbesondere Aluminium als Beschichtungsmaterial 19 der Fall. Dementsprechend werden auch die Korngrößenverteilungen bzw. das Pulver oder die Pulver 37, 40 ausgewählt, d.h. sie enthalten kaum oder keine Pulverteilchen, die eine hohe spezifische Oberfläche aufweisen. Dies kann durch eine entsprechende Morphologie der Körner eingestellt werden.

Als Pulver kann metallisches oder keramisches Pulver oder eine Mischung daraus verwendet werden.
Vorraussetzung ist dabei, dass das Pulver bei der späteren Beschichtung des Bauteils 1, 120, 130, 153, 155 nicht mit dem Bauteil 1, 120, 130, 153, 155 reagiert, es nicht unzulässig verunreinigt oder eine zu starke Haftung an das Bauteil 1, 120, 130, 153, 155 mit sich bringt.
Keramisches Pulver ist am besten geeignet, da Keramik bei den üblichen Beschichtungstemperaturen des Bauteils mit weiteren Schichten chemisch sehr stabil ist.
Besonderes eignet sich Zirkonoxid (vollstabilisiert, teilstabilisiert oder nicht stabilisiert) als Pulver.
Insbesondere wird dann für die Suspension 40wt% Wasser und 60wt% Zirkonoxid verwendet.
Andere Materialien wie Aluminiumoxid, Mischungen von verschiedenen Keramikpulvern sind ebenfalls möglich.
Ebenso können metallische Pulver, Mischungen von verschiedenen Metallpulvern und Mischungen von keramischen und metallischen Pulvern verwendet werden.

Die Beschichtung des Bauteils 1, 120, 130, 153, 155 bestehend aus dem Beschichtungsmaterial 19 wird beispielsweise aufgedampft und erfolgt beispielsweise durch einen CVD-Prozess (Chemical vapour deposition) oder PVD-Prozess (physical vapour deposition) oder Plasmaspritzen.
Dabei herrschen Temperaturen von bis zu 1200°C (Beschichtungstemperatur).
Weitere Beschichtungsarten sind denkbar.
Ebenso können zwei Schichten auf die Bereiche 25 und damit auf die Maskierung aufgebracht werden, beispielsweise eine metallische Zwischenschicht (MCrAlY) und darauf eine keramische Schicht (Wärmedämmschicht)

Die Maskierung 7 und damit die Korngrößenverteilungen der verwendeten Pulver ist so ausgewählt, dass keine oder kaum eine Versinterung erfolgt, da sich die Maskierung 7 sonst nach der Beschichtung schlecht entfernen lassen würde. Dementsprechend wird die Korngröße des Pulvers festgelegt. Jedes Pulver weist aufgrund seiner Korngröße (Korngrößenverteilung) eine Sintertemperatur auf, bei der eine deutliche Verdichtung stattfindet. Die Korngröße des Pulvers wird also so gewählt, dass die Sintertemperatur oberhalb der Beschichtungstemperatur liegt.

Besonders eignet sich die Maskierung 7 für die Aufdampfverfahren, da die Gasphase keinen allzu hohen Eintrag an mechanischer Energie auf die Maskierung 7 erzeugt.

Figur 2 zeigt das Bauteil 1, das beschichtet worden ist.
Es gibt Bereiche 25 auf der Oberfläche 4 mit einer Beschichtung 13 auf dem Bauteil 1, wo diese erwünscht ist. Ebenso gibt es eine Beschichtung 16 auf der Maskierung 7.

Da die Maskierung 7 einfach entfernt werden kann, weil sie nur durch Verklammerung und/oder Adhäsion an dem Bauteil 1 haftet, kommt es in den Bereichen 10, in denen keine Beschichtung erwünscht war, auch zu keiner Beeinträchtigung des Bauteils 1, 120, 130, 153, 155 an der Oberfläche 4 (Fig. 3).

Die Maskierung 7 kann beispielsweise durch Abwaschen, Trockeneisstrahlen, Abklopfen entfernt werden.
Ebenso kann ein Hochdruckwasserstrahl (bis 330 bar) verwendet werden, wobei der Wasserstrahl 31 (Fig. 6) beispielsweise so aufgeweitet ist, dass er aus einer Düse 34 (Fig. 6) großflächig auf die zu entfernende, insbesondere auf die gesamte Maskierung 7 (beispielsweise Schaufelblatt 406) auftrifft und der Strahl nicht über die zu entfernende Maskierung 7 geführt werden muss.
Dazu ist der Wasserstrahl 31 entsprechend aufgeweitet.
Er erfasst beispielsweise eine vollständige Seite der äußeren Schaufelblattfläche einer Turbinenschaufel.

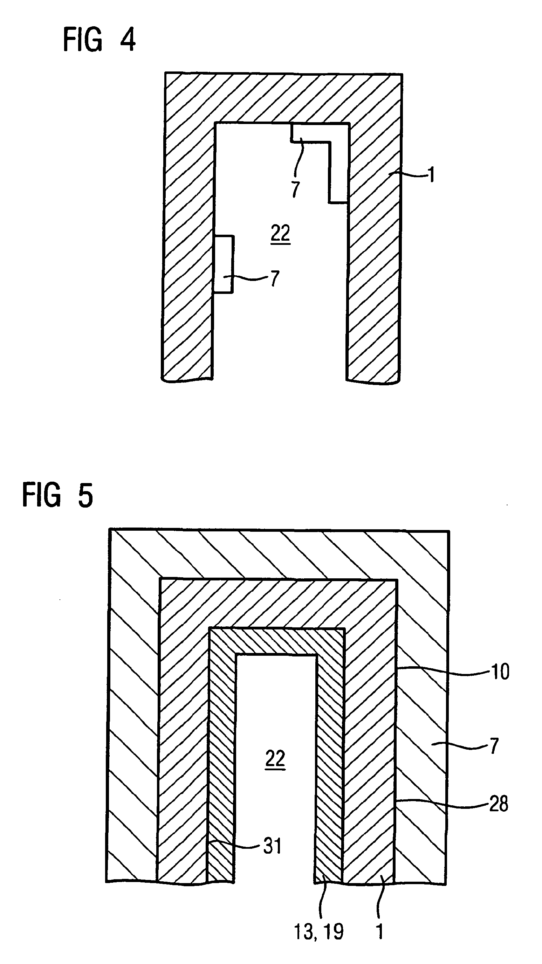

Figur 4 zeigt ein weiteres Anwendungsbeispiel für das erfindungsgemäße Verfahren.
Das Bauteil 1, 120, 130, 153, 155 (Fig. 9, 10) kann auch einen Hohlraum 22 aufweisen, in dem eine Maskierung 7 aufgebracht wird. Das Verfahren eignet sich also nicht nur für außenliegende sondern auch für innenliegende Flächen.

Figur 5 zeigt ein weiteres Anwendungsbeispiel für das erfindungsgemäße Verfahren.
Bei dem Bauteil 1, 120, 130, 153, 155 (Fig. 9, 10) soll eine Beschichtung 13 im Hohlraum 22 des Bauteils 1, 120, 130, 153, 155 erfolgen.
Eine Beschichtung einer äußeren Oberfläche 28, 406 (Fig. 9) des Bauteils 1, 120, 130, 153, 155 ist in diesem Fall nicht erwünscht, so dass eine Maskierung 7 auf die außenliegende Fläche 28, 406 (beispielsweise Schaufelblatt bei Turbinenschaufel) des Bauteils 1, 120, 130, 153, 155 aufgebracht wird.
So kann das ganze Bauteil 1, 120, 130, 153, 155 mit der Maskierung 7 in den Beschichtungsprozess eingeführt werden ohne dass eine Beschichtung 13 in dem Bereich 10 erfolgt, in dem keine Beschichtung erwünscht ist, sondern nur in den gewünschten Bereichen 25 auf einer Innenfläche 31 des Bauteils 1, 120, 130, 153, 155.
Bei Bedarf kann die Innenfläche 31 aber auch an bestimmten gewünschten Stellen durch eine Maskierung 7 geschützt werden.

Dies ist bei der Innenalitierung von Turbinenschaufeln für eine Gasturbine besonders sinnvoll.
Die Beschichtungstemperatur liegt dabei bei etwa 1080°C und das Beschichten erfolgt beispielsweise in Wasserstoffatmosphäre.

Das Verfahren bzw. eine solche Maskierung 7 kann bei neu hergestellten Bauteilen und/oder wieder aufzuarbeitenden Bauteilen verwendet werden.

Wiederaufarbeitung (Refurbishment) bedeutet, dass neu hergestellte Bauteile, die Fehler aufweisen oder Bauteile, die im Einsatz waren, auf Fehler untersucht werden, wie z.B. Risse, die dann aufgefüllt werden. Bei Bauteilen 1, 120, 130, 153, 155 die im Einsatz waren, werden noch Korrosionsprodukte entfernt. Damit kann ein solches Bauteil 1, 120, 130, 153, 155 wieder verwendet werden, wobei zuvor noch metallische und/oder keramische Schutzschichten aufgebracht werden müssen. Dabei wird die Maskierung 7 gemäß dieser Anmeldung verwendet.

Figur 10 zeigt in perspektivischer Ansicht eine Schaufel 120, 130, die sich entlang einer Längsachse 121 erstreckt.
Die Schaufel 120, 130 weist entlang der Längsachse 121 aufeinander folgend einen Befestigungsbereich 400, eine daran angrenzende Schaufelplattform 403 sowie einen Schaufelblattbereich 406 auf. Im Befestigungsbereich 400 ist ein Schaufelfuß 183 gebildet, der zur Befestigung der Laufschaufeln 120, 130 an der Welle dient. Der Schaufelfuß 183 ist als Hammerkopf ausgestaltet. Andere Ausgestaltungen, beispielsweise als Tannenbaum- oder Schwalbenschwanzfuß sind möglich. Bei herkömmlichen Schaufeln 120, 130 werden in allen Bereichen 400, 403, 406 der Laufschaufel 120, 130 massive metallische Werkstoffe verwendet. Die Laufschaufel 120, 130 kann hierbei durch ein Gussverfahren, durch ein Schmiedeverfahren, durch ein Fräsverfahren oder Kombinationen daraus gefertigt sein.

Die Figur 11 zeigt eine Brennkammer 110 einer Gasturbine.
Die Brennkammer 110 ist beispielsweise als so genannte Ringbrennkammer ausgestaltet, bei der eine Vielzahl von in Umfangsrichtung um die Turbinenwelle 103 herum angeordneten Brennern 102 in einen gemeinsamen Brennkammerraum münden. Dazu ist die Brennkammer 110 in ihrer Gesamtheit als ringförmige Struktur ausgestaltet, die um die Turbinenwelle 103 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen. Jedes Hitzeschildelement 155 ist arbeitsmediumsseitig mit einer besonders hitzebeständigen Schutzschicht ausgestattet oder aus hochtemperaturbeständigem Material gefertigt. Aufgrund der hohen Temperaturen im Inneren der Brennkammer 110 ist zudem für die Hitzeschildelemente 155 bzw. für deren Halteelemente ein Kühlsystem vorgesehen.

Die Materialien der Brennkammerwand und deren Beschichtungen können ähnlich der Turbinenschaufeln 120, 130 sein.

Die Brennkammer 110 ist insbesondere für eine Detektion von Verlusten der Hitzeschildelemente 155 ausgelegt. Dazu sind zwischen der Brennkammerwand 153 und den Hitzeschildelementen 155 eine Anzahl von Temperatursensoren 158 positioniert.

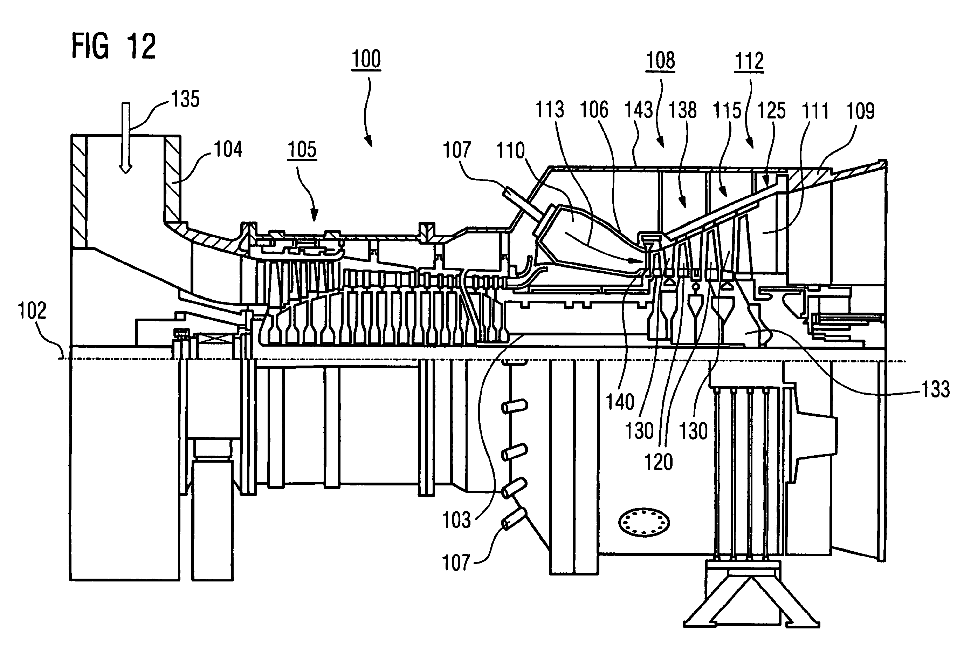

Die Figur 12 zeigt beispielhaft eine Gasturbine 100 in einem Längsteilschnitt.
Die Gasturbine 100 weist im Inneren einen um eine Rotationsachse 102 drehgelagerten Rotor 103 auf, der auch als Turbinenläufer bezeichnet wird.
Entlang des Rotors 103 folgen aufeinander ein Ansauggehäuse 104, ein Verdichter 105, eine beispielsweise torusartige Brennkammer 110, insbesondere Ringbrennkammer 106, mit mehreren koaxial angeordneten Brennern 107, eine Turbine 108 und das Abgasgehäuse 109.
Die Ringbrennkammer 106 kommuniziert mit einem beispielsweise ringförmigen Heißgaskanal 111. Dort bilden beispielsweise vier hintereinandergeschaltete Turbinenstufen 112 die Turbine 108.
Jede Turbinenstufe 112 ist aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind. An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt.

Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 106 auskleidenden Hitzeschildsteinen am meisten thermisch belastet.
Um den dort herrschenden Temperaturen standzuhalten, werden diese mittels eines Kühlmittels gekühlt.
Ebenso können die Substrate eine gerichtete Struktur aufweisen, d.h. sie sind einkristallin (SX-Struktur) oder weisen nur längsgerichtete Körner auf (DS-Struktur).
Als Material werden eisen-, nickel- oder kobaltbasierte Superlegierungen verwendet.
Beispielsweise werden Superlegierungen verwendet, wie sie aus der EP 1204776, EP 1306454, EP 1319729, WO 99/67435 oder WO 00/44949 bekannt sind; diese Schriften sind Teil der Offenbarung.

Ebenso können die Schaufeln 120, 130 Beschichtungen gegen Korrosion (MCrAlX; M ist zumindest ein Element der Gruppe Eisen (Fe), Kobalt (Co), Nickel (Ni), X steht für Yttrium (Y) und/oder Silizium (Si) und/oder zumindest ein Element der Seltenen Erden) und Wärme durch eine Wärmedämmschicht aufweisen. Die Wärmedämmschicht besteht beispielsweise ZrO₂, Y₂O₄-ZrO₂, d.h. sie ist nicht, teilweise oder vollständig stabilisiert durch Yttriumoxid und/oder Kalziumoxid und/oder Magnesiumoxid.

Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

### Bezugszeichenliste

- 1: Bauteil
- 4: Oberfläche von 1
- 7: Maskierung
- 10: Bereich unerwünschter Beschichtung
- 13: Beschichtung auf 1
- 16: Beschichtung auf 7
- 19: Beschichtungsmaterial
- 22: Hohlraum
- 28: Außenfläche
- 31: Innenfläche

## Patentansprüche

1. Verfahren zur Beschichtung einer Oberfläche (4) eines Bauteils (1, 120, 130, 153, 155),
insbesondere einer Turbinenschaufel (120, 130),
das zumindest folgende Schritte umfasst:
- Aufbringung einer Maskierung (7) auf bestimmte Bereiche (10, 406) der Oberfläche (4) des Bauteils (1, 120, 130, 153, 155),
die keine Beschichtung aufweisen sollen,
- Beschichtung (13) des Bauteils (1, 120, 130, 153, 155),
**dadurch gekennzeichnet,**
**dass** als Maskierung (7) Pulver (37, 40) ohne Bindemittelzusatz verwendet wird und
**dass** verschiedene Pulver (37, 40) mit verschiedenen Korngrößenverteilungen für die Maskierung (7) verwendet werden.

2. Verfahren nach Anspruch 1,
**dadurch gekennzeichnet, dass**
die Maskierung (7) aus einer Suspension mit dem Pulver (37, 40) auf die Bereiche (10, 406) aufgebracht wird.

3. Verfahren nach Anspruch 2,
**dadurch gekennzeichnet, dass**
die verwendete Suspension nur aus einem Trägermittel und einem Pulver (37, 40) besteht.

4. Verfahren nach Anspruch 3,
**dadurch gekennzeichnet, dass**
als Trägermittel Wasser verwendet wird.

5. Verfahren nach Anspruch 2, 3 oder 4,
**dadurch gekennzeichnet, dass**
eine Suspension aus 30-50wt%, insbesondere 40wt% Trägermittel und 70-50wt%, insbesondere 60wt% Pulver verwendet wird.

6. Verfahren nach Anspruch 2, 3 oder 5,
**dadurch gekennzeichnet, dass**
die Suspension aufgesprüht wird.

7. Verfahren nach Anspruch 1, 2, 3, 5 oder 6,
**dadurch gekennzeichnet, dass**
ein keramisches Pulver verwendet wird.

8. Verfahren nach Anspruch 1, 2, 3, 5 oder 6,
**dadurch gekennzeichnet, dass**
ein metallisches Pulver verwendet wird.

9. Verfahren nach Anspruch 7,
**dadurch gekennzeichnet, dass**
als Keramikpulver zumindest teilweise,
insbesondere zu 100% ein Zirkonoxidpulver verwendet wird.

10. Verfahren nach Anspruch 1,
**dadurch gekennzeichnet, dass**
die Beschichtung (13) auf das Bauteil (1, 120, 130, 153, 155) mit der Maskierung (7),
insbesondere auf einer Innenfläche (31) des Bauteils (1, 120, 130, 153, 155),
aufgedampft wird.

11. Verfahren nach Anspruch 1 oder 10,
**dadurch gekennzeichnet, dass**
auf das Bauteil (1, 120, 130, 153, 155) eine Aluminiumschicht (13) aufgebracht wird.

12. Verfahren nach Anspruch 10 oder 11,
**dadurch gekennzeichnet, dass**
die Beschichtung (13) durch einen Chemical-Vapour-Deposition -(CVD-) Prozess erfolgt.

13. Verfahren nach Anspruch 10 oder 11,
**dadurch gekennzeichnet, dass**
die Beschichtung (13) durch einen Physical-Vapour-Deposition -(PVD-) Prozess erfolgt.

14. Verfahren nach Anspruch 1 oder 10,
**dadurch gekennzeichnet, dass**
die Maskierung (7) so aufgebracht wird, dass sie gegenüber einem Metall- oder Keramikdampf eine geschlossene Oberfläche aufweist.

15. Verfahren nach Anspruch 10, 11, 12 oder 13,
**dadurch gekennzeichnet, dass**
die Maskierung (7) nach dem Aufbringen der Beschichtung (13) großflächig durch Hochdruckwasserstrahlen entfernt wird.

16. Verfahren nach Anspruch 1,
**dadurch gekennzeichnet, dass**
das Verfahren bei neu hergestellten Bauteilen (1, 120, 130, 153, 155) angewendet wird.

17. Verfahren nach Anspruch 1,
**dadurch gekennzeichnet, dass**
das Verfahren bei wieder aufzuarbeitenden Bauteilen (1, 120, 130, 153, 155) angewendet wird.

18. Verfahren nach Anspruch 1 oder 14,
**dadurch gekennzeichnet, dass**
eine Korngrößenverteilung des Pulvers (37, 40) für die Maskierung (7) so ausgewählt wird,
dass die Maskierung (7) eine geschlossene Oberfläche aufweist.

19. Verfahren nach Anspruch 1,
**dadurch gekennzeichnet, dass**
zumindest ein grobes Pulver (37) und zumindest ein feines Pulver (40) für die Maskierung (7) verwendet wird.

20. Verfahren nach Anspruch 1, 14, 18 oder 19,
**dadurch gekennzeichnet, dass**
für die Maskierung (7)
10wt% bis 30wt%, insbesondere 15wt% bis 20wt% feines Pulver (40) und
70wt% bis 90wt%, insbesondere 80wt% bis 85wt% grobes Pulver (37) verwendet wird.

21. Verfahren nach Anspruch 1, 10, 11, 12, 13, 19 oder 20,
**dadurch gekennzeichnet, dass**
die Beschichtung (13) bei einer Beschichtungstemperatur stattfindet, die kleiner ist als die Sintertemperatur des Pulvers,
das einen Grobanteil (37) und einen Feinanteil (40) aufweist.

22. Bauteil (1, 120, 130, 153, 155),
insbesondere für eine Gas- (100) oder Dampfturbine,
insbesondere eine Turbinenschaufel (120, 130),
das zur Beschichtung (13) vorgesehen ist und
eine Maskierungsschicht (7) auf bestimmten Bereichen (10) der Oberfläche (4) des Bauteils (1, 120, 130, 153, 155) aufweist,
die keine Beschichtung erhalten sollen,
**dadurch gekennzeichnet, dass**
die Maskierung (7) nur aus Pulver (37, 40) besteht,
die Maskierung (7) verschiedene Pulver (37, 40) mit verschiedenen Korngrößenverteilungen aufweist.

23. Bauteil nach Anspruch 22,
**dadurch gekennzeichnet, dass**
das Pulver (37, 40) keramisch ist.

24. Bauteil nach Anspruch 22,
**dadurch gekennzeichnet, dass**
die Maskierung (7) eine Dicke von 100µm bis 400µm, insbesondere 180µm bis 200µm aufweist.

25. Bauteil nach Anspruch 22 oder 24,
**dadurch gekennzeichnet, dass**
die Maskierung (7) eine derart geschlossene Oberfläche aufweist, dass kein Beschichtungsmaterial (19) durch die Maskierung (7) bis zu dem Bereich (10) dringen kann.

26. Bauteil nach Anspruch 22 oder 25,
**dadurch gekennzeichnet, dass**
die Maskierung (7) zumindest ein grobes Pulver (37) und zumindest ein feines Pulver (40) aufweist.

27. Bauteil nach Anspruch 22 oder 23,
**dadurch gekennzeichnet, dass**
das Pulver (37, 40) aus Zirkonoxid besteht.

28. Verfahren nach Anspruch 22, 26 oder 27,
**dadurch gekennzeichnet, dass**
die Maskierung (7)
10wt% bis 30wt%, insbesondere 15wt% bis 20wt% feines Pulver, und
70wt% bis 90wt%, insbesondere 80wt% bis 85wt% grobes Pulver aufweist.

29. Bauteil nach Anspruch 22, 25, 27 oder 28,
**dadurch gekennzeichnet, dass**
die mittlere Korngrößenverteilung des Pulvers der Maskierung (7) folgende Werte aufweist:
d₁₀ = 0.1µm - 6µm, insbesondere 0.2µm - 1µm,
d₅₀ = 1µm - 15µm, insbesondere 3µm - 6µm,
d₉₀ = 6µm - 40µm, insbesondere 15µm - 25µm.

30. Bauteil nach Anspruch 22, 26, 28 oder 29,
**dadurch gekennzeichnet, dass**
das grobe Pulver (37) eine Korngrößenverteilung aufweist, bei der eine Versinterung während der Beschichtung nicht oder kaum stattfindet.

31. Bauteil nach Anspruch 22 oder 27,
**dadurch gekennzeichnet, dass**
das Bauteil (1, 120, 130, 153, 155) aus einer eisen-, nickel-, oder kobalt-basierten Superlegierung besteht.

## Claims

1. Process for coating a surface (4) of a component (1, 120, 130, 153, 155), in particular a turbine blade or vane (120, 130), which comprises at least the following steps:
- application of a masking (7) to certain regions (10, 406) of the surface (4) of the component (1, 120, 130, 153, 155) which are not to be provided with a coating,
- coating (13) the component (1, 120, 130, 153, 155),
**characterized in that** powders (37, 40) without added binder are used as masking (7) and **in that** various powders (37, 40) with various grain size distributions are used for the masking (7).

2. Process according to Claim 1, **characterized in that** the masking (7) is applied to the regions (10, 406) from a suspension comprising the powder (37, 40).

3. Process according to Claim 2, **characterized in that** the suspension used consists only of a carrier medium and a powder (37, 40).

4. Process according to Claim 3, **characterized in that** the carrier medium used is water.

5. Process according to Claim 2, 3 or 4, **characterized in that** a suspension comprising 30-50% by weight, in particular 40% by weight, of carrier medium and 70-50% by weight, in particular 60% by weight, of powder is used.

6. Process according to Claim 2, 3 or 5, **characterized in that** the suspension is sprayed on.

7. Process according to Claim 1, 2, 3, 5 or 6, **characterized in that** a ceramic powder is used.

8. Process according to Claim 1, 2, 3, 5 or 6, **characterized in that** a metallic powder is used.

9. Process according to Claim 7, **characterized in that** the ceramic powder used is at least partially, and in particular 100%, a zirconium oxide powder.

10. Process according to Claim 1, **characterized in that** the coating (13) is evaporation-coated onto the component (1, 120, 130, 153, 155) having the masking (7), in particular on an inner surface (31) of the component (1, 120, 130, 153, 155).

11. Process according to Claim 1 or 10, **characterized in that** an aluminum layer (13) is applied to the component (1, 120, 130, 153, 155).

12. Process according to Claim 10 or 11, **characterized in that** the coating (13) is performed by a chemical vapor deposition (CVD) process.

13. Process according to Claim 10 or 11, **characterized in that** the coating (13) is performed by a physical vapor deposition (PVD) process.

14. Process according to Claim 1 or 10, **characterized in that** the masking (7) is applied in such a way that it has a surface which is impervious to a metal or ceramic vapor.

15. Process according to Claim 10, 11, 12 or 13, **characterized in that** the masking (7) is removed by high-pressure water blasting over a large area after the coating (13) has been applied.

16. Process according to Claim 1, **characterized in that** the process is used for newly produced components (1, 120, 130, 153, 155).

17. Process according to Claim 1, **characterized in that** the process is used for components (1, 120, 130, 153, 155) which are to be refurbished.

18. Process according to Claim 1 or 14, **characterized in that** a grain size distribution of the powder (37, 40) for the masking (7) is selected in such a way that the masking (7) has an impervious surface.

19. Process according to Claim 1, **characterized in that** at least one coarse powder (37) and at least one fine powder (40) are used for the masking (7).

20. Process according to Claim 1, 14, 18 or 19, **characterized in that**
10% by weight to 30% by weight, in particular 15% by weight to 20% by weight, of fine powder (40) and
70% by weight to 90% by weight, in particular 80% by weight to 85% by weight, of coarse powder (37) is used for the masking (7).

21. Process according to Claim 1, 10, 11, 12, 13, 19 or 20, **characterized in that** the coating (13) takes place at a coating temperature which is lower than the sintering temperature of the powder which has a coarse fraction (37) and a fine fraction (40).

22. Component (1, 120, 130, 153, 155), in particular for a gas turbine (100) or steam turbine, in particular a turbine blade or vane (120, 130), which is intended for coating (13) and has a masking layer (7) on certain regions (10) of the surface (4) of the component (1, 120, 130, 153, 155) which are not to receive a coating, **characterized in that** the masking (7) consists only of powder (37, 40), the masking (7) includes various powders (37, 40) with various grain size distributions.

23. Component according to Claim 22, **characterized in that** the powder (37, 40) is ceramic.

24. Component according to Claim 22, **characterized in that** the masking (7) has a thickness of 100 µm to 400 µm, in particular 180 µm to 200 µm.

25. Component according to Claim 22 or 24, **characterized in that** the masking (7) has an impervious surface which is such that it is impossible for any coating material (19) to penetrate through the masking (7) to the region (10).

26. Component according to Claim 22 or 25, **characterized in that** the masking (7) includes at least one coarse powder (37) and at least one fine powder (40).

27. Component according to Claim 22 or 23, **characterized in that** the powder (37, 40) consists of zirconium oxide.

28. Process according to Claim 22, 26 or 27, **characterized in that** the masking (7) contains 10% by weight to 30% by weight, in particular 15% by weight to 20% by weight, of fine powder, and 70% by weight to 90% by weight, in particular 80% by weight to 85% by weight, of coarse powder.

29. Component according to Claim 22, 25, 27 or 28, **characterized in that** the mean grain size distribution of the powder of the masking (7) has the following values:
d₁₀ = 0.1 µm 6 µm, in particular 0.2 µm - 1 µm,
d₅₀ = 1 µm - 15 µm, in particular 3 µm - 6 µm,
d₉₀ = 6 µm - 40 µm, in particular 15 µm - 25 µm.

30. Component according to Claim 22, 26, 28 or 29, **characterized in that** the coarse powder (37) has a grain size distribution with which sintering does not occur or scarcely occurs during the coating.

31. Component according to Claim 22 or 27, **characterized in that** the component (1, 120, 130, 153, 155) consists of an iron-base, nickel-base or cobalt-base superalloy.

## Revendications

1. Procédé de revêtement d'une surface ( 4 ) d'un élément ( 1, 120, 130, 153, 155 ) constitutif,
notamment d'une aube ( 120, 130 ) de turbine,
qui comprend au moins les stades suivantes :
- on dépose un masquage ( 7 ) sur des zones ( 10, 406 ) déterminées de la surface ( 4 ) de l'élément ( 1, 120, 130, 153, 155 ) constitutif,
- qui ne doivent pas avoir de revêtement,
- on revêt ( 13 ) l'élément ( 1, 120, 130, 153, 155 ) constitutif,
**caractérisé**
**en ce que** l'on utilise comme masquage ( 7 ) de la poudre ( 37, 40 ) sans addition de liant et
**en ce que** l'on utilise des poudres ( 37, 40 ) différentes ayant des répartitions granulométriques différentes pour le masquage ( 7 ).

2. Procédé suivant la revendication 1,
**caractérisé en ce que**
on dépose le masquage ( 7 ) sur les zones ( 10, 406 ) le masquage ( 7 ) en une suspension ayant la poudre ( 37, 40 ).

3. Procédé suivant la revendication 2,
**caractérisé en ce que**
la suspension utilisée n'est constituée que d'un support et d'une poudre ( 37, 40 ).

4. Procédé suivant la revendication 3,
**caractérisé en ce que**
on utilise de l'eau comme support.

5. Procédé suivant la revendication 2, 3 ou 4,
**caractérisé en ce que**
on utilise une suspension constituée de 30 à 50 % en poids, notamment de 40 % en poids, de support et de 70 à 50 % en poids, notamment de 60 % en poids, de poudre.

6. Procédé suivant la revendication 2, 3 ou 5,
**caractérisé en ce que**
on pulvérise la suspension.

7. Procédé suivant la revendication 1, 2, 3, 5 ou 6,
**caractérisé en ce que**
on utilise une poudre céramique.

8. Procédé suivant la revendication 1, 2, 3, 5 ou 6,
**caractérisé en ce que**
on utilise une poudre métallique.

9. Procédé suivant la revendication 7,
**caractérisé en ce que**
on utilise comme poudre céramique au moins en partie, notamment à 100 %, une poudre d'oxyde de zirconium.

10. Procédé suivant la revendication 1,
**caractérisé en ce que**
on dépose en phase vapeur le revêtement ( 13 ) sur l'élément ( 1, 120, 130, 153, 155 ) constitutif ayant le masquage ( 7 ), notamment sur une surface ( 31 ) intérieure de l'élément ( 1, 120, 130, 153, 155 ) constitutif.

11. Procédé suivant la revendication 1 ou 10,
**caractérisé en ce que**
on dépose une couche ( 13 ) d'aluminium sur l'élément ( 1, 120, 130, 153, 155 ) constitutif.

12. Procédé suivant la revendication 10 ou 11,
**caractérisé en ce que**
on effectue le revêtement ( 13 ) par une opération chemical-vapour-deposition ( CVD ).

13. Procédé suivant la revendication 10 ou 11,
**caractérisé en ce que**
on effectue le revêtement par une opération physical-vapour-deposition ( PVD ).

14. Procédé suivant la revendication 1 ou 10,
**caractérisé en ce que**
on dépose le masquage ( 7 ) de manière à ce qu'il ait une surface fermée vis à vis d'une vapeur métallique ou d'une vapeur céramique.

15. Procédé suivant la revendication 10, 11, 12 ou 13,
**caractérisé en ce que**
on élimine par des jets d'eau sous haute pression sur une grande surface le masquage (7 ) après le dépôt du revêtement ( 13 ).

16. Procédé suivant la revendication 1,
**caractérisé en ce que**
on applique le procédé à des éléments ( 1, 120, 130, 153, 155 ) nouvellement fabriqués.

17. Procédé suivant la revendication 1,
**caractérisé en ce que**
on applique le procédé à des éléments ( 1, 120, 130, 153, 155 ) à retraiter.

18. Procédé suivant la revendication 1 ou 14,
**caractérisé en ce que**
on choisit une répartition granulométrique de la poudre ( 37, 40 ) pour le masquage ( 7 ) telle,
que le masquage ( 7 ) ait une surface fermée.

19. Procédé suivant la revendication 1,
**caractérisé en ce que**
on utilise au moins une poudre ( 37 ) grossière et au moins une poudre ( 40 ) fine pour le masquage ( 7 ).

20. Procédé suivant la revendication 1, 14, 18 ou 19,
**caractérisé en ce que**
on utilise pour le masquage ( 7 )
de 10 % en poids à 30 % en poids, notamment de 15 % en poids à 20 % en poids, de poudre ( 40 ) fine et
de 70 % en poids à 90% en poids, notamment de 80 % en poids à 85 % en poids, de poudre ( 37 ) grossière.

21. Procédé suivant la revendication 1, 10, 11, 12, 13, 19 ou 20,
**caractérisé en ce que**
le revêtement ( 13 ) a lieu à une température de revêtement qui est plus petite que la température de frittage de la poudre,
dont une proportion ( 37 ) est grossière et dont une proportion ( 40 ) est fine.

22. Elément ( 1, 120, 130, 153, 155 ) constitutif,
notamment pour une turbine à gaz ( 100 ) ou à vapeur,
notamment une aube ( 120, 130 ) de turbine,
qui est destiné à être revêtu ( 13 ) et
qui a une couche ( 7 ) de masquage sur des zones ( 10 ) déterminées de la surface ( 4 ) de l'élément ( 1, 120, 130, 153, 155 ) constitutif,
qui ne doivent pas recevoir de revêtement,
**caractérisé en ce que**
le masquage ( 7 ) est constitué seulement de poudre ( 37, 40 ),
le masquage ( 7 ) a des poudres ( 37, 40 ) différentes ayant des répartitions granulométriques différentes.

23. Elément suivant la revendication 22,
**caractérisé en ce que**
la poudre ( 37, 40 ) est céramique.

24. Elément suivant la revendication 22,
**caractérisé en ce que**
le masquage ( 7 ) a une épaisseur de 100 µm à 400 µm, notamment de 180 µm à 200 µm.

25. Elément suivant la revendication 22 ou 24,
**caractérisé en ce que**
le masquage ( 7 ) a une surface fermée de manière à ce que de la matière ( 19 ) de revêtement ne puisse pas pénétrer à travers le masquage ( 7 ) jusqu'à la zone ( 10 ).

26. Elément suivant la revendication 22 ou 25,
**caractérisé en ce que**
le masquage ( 7 ) a une poudre ( 37 ) grossière et au moins une poudre ( 40 ) fine.

27. Elément suivant la revendication 22 ou 23,
**caractérisé en ce que**
la poudre ( 37, 40 ) est en oxyde de zirconium.

28. Procédé suivant la revendication 22, 26 ou 27,
**caractérisé en ce que**
le masquage ( 7 ) a
de 10 % en poids à 30 % en poids, notamment de 15 % en poids à 20 % en poids, de poudre fine, et
de 70 % en poids à 90 % en poids, notamment de 80 % en poids à 85 % en poids, de poudre grossière.

29. Elément suivant la revendication 22, 25, 27 ou 28,
**caractérisé en ce que**
la répartition granulométrique moyenne de la poudre du masquage ( 7 ) a les valeurs suivantes :
d₁₀ = 0,1 µm à 6 µm, notamment 0,2 µm à 1 µm,
d₅₀ = 1 µm à 15 µm, notamment 3 µm à 6 µm,
d₉₀ = 6 µm à 40 µm, notamment 15 µm à 25 µm.

30. Elément suivant la revendication 22, 26, 28 ou 29,
**caractérisé en ce que**
la poudre ( 37 ) grossière a une répartition granulométrique pour laquelle un frittage n'a pas lieu ou n'a guère lieu pendant le revêtement.

31. Elément suivant la revendication 22 ou 27,
**caractérisé en ce que**
l'élément ( 1, 120, 130, 153, 155 ) constitutif est en un superalliage à base de nickel ou à base de cobalt.
